# EUROPÄISCHE PATENTANMELDUNG

(11) **EP 2 578 322 A1**
(43) Veröffentlichungstag der Anmeldung: **10.04.2013**
(21) Anmeldenummer: 11183828.0
(22) Anmeldetag: 04.10.2011
(51) Int. Cl.: B05D 1/26, F24J 2/46, G01N 21/35, G01N 27/20, G01N 29/04, B05C 5/02, B05D 5/00

(54) **Verfahren und Anordnung zur Herstellung einer Verbundkonstruktion**

(71) Anmelder: Sika Technology AG, 6340 Baar (CH)
(72) Erfinder: Buck, Manuel, 5412 Gebenstorf (CH)
(74) Vertreter: Sika Patent Attorneys

(57) **Zusammenfassung**

Verfahren zur Herstellung einer Verbundkonstruktion mit einem rahmen- oder wannenförmigen Trägerteil (T) und einer in dieses eingefügten und an ihren Kanten mit dem Trägerteil verklebten Platte (G; 7), wobei Klebstoff (11) aus einer längs der Kante der Platte vorgeschobenen Klebstoffaustragvorrichtung (H; 9) fortschreitend in eine längs der Kante der Platte verlaufende Vertiefung (5) ausgetragen wird, die sich von einer außerhalb der Projektion der Platte auf das Trägerteil liegenden Außenkante (1) bis zu einer innerhalb der Projektion liegenden Innenkante (3) erstreckt, wobei der Verlauf der Vorderfront (11a) einer sich beim fortschreitenden Klebstoffaustrag in der Vertiefung bildenden Klebstoffschicht (11) bildgebend oder sensorisch erfasst und ausgewertet und die Vorschubgeschwindigkeit der Klebstoffaustragvorrichtung und/oder die Klebstoff-Austragmenge pro Zeiteinheit in Abhängigkeit vom Auswertungsergebnis gesteuert wird.

## Beschreibung

### Technisches Gebiet

Die Erfindung betrifft ein Verfahren zur Herstellung einer Verbundkonstruktion mit einem rahmen- oder wannenförmigen Trägerteil und einer in dieses eingefügten und an ihren Kanten mit dem Trägerteil verklebten Platte, wobei Klebstoff aus einer längs der Kante der Platte vorgeschobenen Klebstoffaustragvorrichtung fortschreitend in eine längs der Kante der Platte verlaufende Vertiefung ausgetragen wird, die sich von einer außerhalb der Projektion der Platte auf das Trägerteil liegenden Außenkante bis zu einer innerhalb der Projektion liegenden Innenkante erstreckt. Sie betrifft des Weiteren eine Anordnung zur Durchführung eines solchen Verfahrens.

### Stand der Technik

Seit die Nutzung der Sonnenenergie mittels Solarthermie- oder Photovoltaik-Anlagen nennenswerten Umfang erreicht hat, werden geeignete Anlagen in Serienproduktion hergestellt. Es handelt sich dabei üblicherweise um Verbundkonstruktionen mit einem rahmen- oder wannenförmigen Trägerteil und einer in dieses eingefügten und an ihren Kanten mit dem Trägerteil verklebten Platte. Zum Verbinden der Platte mit dem Trägerteil wird Klebstoff aus einer längs der Kante der Platte vorgeschobenen Klebstoffaustragvorrichtung fortschreitend in eine längs der Kante der Platte verlaufende Vertiefung ausgetragen, die sich von einer außerhalb der Projektion der Platte auf das Trägerteil liegenden Außenkante bis zu einer innerhalb der Projektion liegenden Innenkante erstreckt.

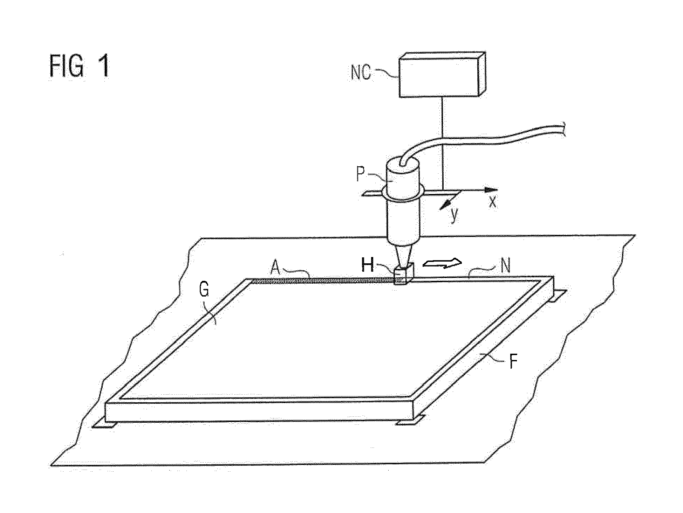

Fig. 1 zeigt skizzenartig den Einsatz einer mit einem erfindungsgemäßen Applikatorkopf H bestückten, pumpenbetriebenen und koordinatengesteuerten Applikationsvorrichtung P für den industriellen Einsatz zur Herstellung einer Fugenverklebung A in einer umlaufenden Nut N, die zwischen einem Tragrahmen F eines Solarkollektors und einer hierin einzusetzenden Glasplatte G vorhanden ist. Eine Koordinatensteuereinheit NC der Applikationsvorrichtung ist so programmiert, dass sie die Applikationsvorrichtung mit einer zum vollständigen Füllen der Nut N geeigneten Geschwindigkeit längs der Nut führt.

In ähnlicher Weise können Prozesse zur Herstellung von großflächigen Verglasungselementen, etwa zur Herstellung von Fassaden, Wintergärten, Glasdächern oder auch Glas-Innenwänden, ablaufen.

Hierbei ist zur Erzielung einer hohen Qualität der hergestellten Verbundkonstruktionen neben der Klebstoffqualität auch eine angemessene Steuerung des Klebstoffaustrags längs der zu verklebenden Kanten von Bedeutung.

Der Erfindung liegt daher die Aufgabe zugrunde, ein zur Erzielung hoher Produktqualität bei gleichzeitig hoher Produktionsausbeute geeignetes Verfahren der gattungsgemäßen Art anzugeben. Des Weiteren soll eine Anordnung zur Durchführung dieses Verfahrens bereitgestellt werden.

### Offenbarung der Erfindung

Diese Aufgabe wird in ihrem Verfahrensaspekt durch ein Verfahren mit den Merkmalen des Anspruchs 1 gelöst. Vorrichtungsseitig wird sie durch eine Anordnung mit den Merkmalen des Anspruchs 10 gelöst. Zweckmäßige Fortbildungen des Erfindungsgedankens sind Gegenstand der jeweiligen abhängigen Ansprüche.

Die Erfindung geht von der Beobachtung aus, dass beim Eintrag von pastösem Klebstoff in die weiter oben spezifizierte Vertiefung längs der Kante der Verbundkonstruktion sich dort im kantennahen Bereich eine mit der Klebstoffaustragvorrichtung wandernde Klebstofffront ausbildet, deren Verlauf erheblichen Einfluss auf eine zufriedenstellende Prozessführung hat. Der Erfinder hat bei manuell ausgeführten Verklebungen den Vorschub einer von Hand gehaltenen Klebstoffaustragvorrichtung unter Beobachtung des Verlaufs der Vorderfront der Klebstoffschicht variiert und dabei Ergebnisse von erheblich unterschiedlicher Qualität erhalten. Die Erfindung schließt mithin auch den Gedanken ein, eine entsprechende intuitive manuelle Steuerung durch eine regelbasierte automatische Steuerung auf der gleichen Ausgangsbasis, nämlich der Erfassung des Verlaufs der Vorderfront der Klebstoffschicht, zu ersetzen.

Während als zu variierende Parameter sowohl die Vorschubgeschwindigkeit der Klebstoffaustragvorrichtung als auch die Klebstoff-Austragmenge pro Zeiteinheit in Betracht kommen, ist es aus derzeitigem Erkenntnisstand bevorzugt, dass bei konstant gehaltener Klebstoffaustragmenge pro Zeiteinheit nur die Vorschubgeschwindigkeit in Abhängigkeit vom Auswertungsergebnis verändert wird. Eine Variation der Klebstoffaustragmenge pro Zeiteinheit führt nämlich zu gewissen Regelschwankungen, die zumindest die Sauberkeit, gegebenenfalls aber auch die Festigkeit der Verklebung nachteilig beeinflussen können.

In einer weiteren Ausführung der Erfindung ist vorgesehen, dass die Auswertung einen Muster- oder Koordinatensatz-Vergleich eines in Echtzeit erfassten Bildes oder Koordinatensatzes mit gespeicherten Bildern oder Punktschaaren von Vorderfronten umfasst. Spezieller ist hierbei jedem Bild oder jeder Punktschaar ein Steuerdatensatz zugeordnet, welcher bei Erkennung einer Übereinstimmung im Mustervergleich zur Steuerung der Vorschubgeschwindigkeit und/oder Klebstoffaustragmenge pro Zeiteinheit benutzt wird.

Das bei der Verfahrensführung gewählte Erfassungsverfahren hängt davon ab, ob und in welchem Maße die auf dem Trägerteil zu befestigende Platte transparent und somit die sich darunter fortbewegende Vorderfront der Klebstoffschicht optisch zu erfassen ist. Bei hinreichender Transparenz im sichtbaren Bereich oder IR-Bereich wird zweckmäßigerweise mit einer in diesem Bereich arbeitenden (Video-)Kamera gearbeitet. Ist die Platte im sichtbaren oder Infrarotbereich nicht oder nur geringfügig transparent, wie dies etwa bei zu einem Photovoltaikmodul zusammenzufügenden Solarzellen üblicherweise der Fall ist, kann mit einem bildgebenden Ultraschallverfahren gearbeitet werden. Darüber hinaus sind grundsätzlich auch weitere Erfassungsverfahren einsetzbar, so etwa Leitfähigkeitsmessungen, bei denen Daten auf vorbestimmten Linien längs der Kante der Platte zwischen Außen-und Innenkante der Vertiefung erfasst und hieraus jeweils den Verlauf der Vorderfront charakterisierende Koordinatensätze gewonnen werden.

Vorrichtungsaspekte der Erfindung ergeben sich weitgehend ohne Weiteres aus den weiter oben erläuterten Verfahrensaspekten und werden insoweit hier nicht nochmals beschrieben. Es wird aber besonders darauf hingewiesen, dass vorteilhafterweise die Bildaufnahme- oder Sensoreinrichtung mit der Klebstoffaustragsvorrichtung mechanisch gekoppelt ist und mit dieser vorgeschoben wird, derart, dass jeweils nur ein Bereich der Kante der Platte bildgebend oder sensorisch erfasst wird, in dem sich die Vorderkante der Klebstoffschicht ausbildet.

### Beschreibung der Zeichnungen

Vorteile und Zweckmäßigkeiten der Erfindung werden aus der nachfolgenden Beschreibung bevorzugter Ausführungsbeispiele anhand der Figuren deutlich. Von diesen zeigen:
Fig. 1 eine skizzenartige Darstellung zur Erläuterung eines gattungsgemäßen Verfahrens,
Fig. 2A und 2B zwei beispielhafte Detailansichten der Vorderfront von mit unterschiedlicher Vorschubgeschwindigkeit beim vorliegenden Verfahren ausgetragenen Klebstoffschichten und
Fig. 3 eine schematische Darstellung einer Ausführungsform der erfindungsgemäßen Anordnung in Art eines Blockschaltbildes.

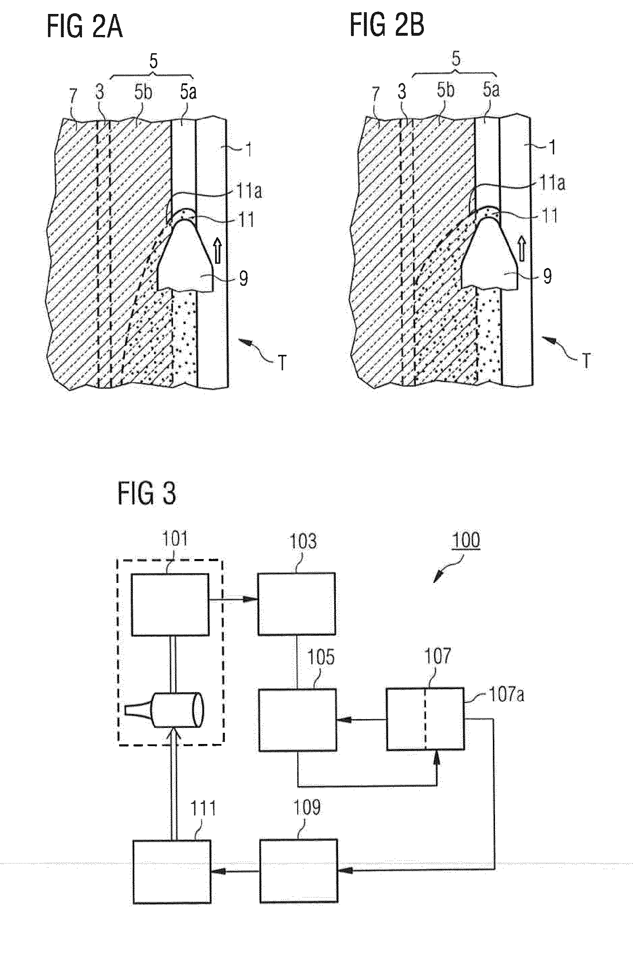

Fig. 2A und 2B zeigen jeweils einen Ausschnitt des in Fig. 1 insgesamt dargestellten Werkstücks, nämlich eine Längskante 1 eines Solarkollektor-Tragrahmens, der eine hierzu parallel verlaufende Innenkante 3 hat. Zwischen diesen ist eine langgestreckte Vertiefung 5 ausgebildet. Auf der gegenüber der Vertiefung 5 aufstehenden Innenkante 3 liegt eine Glasplatte 7 derart auf, dass bis zur inneren Begrenzung der Außenkante 1 ein Spaltbereich 5a vorliegt, der nicht von der Glasplatte bedeckt, also von oben her zugänglich ist. Der verbleibende Breitenabschnitt 5b der Vertiefung 5 ist von der Glasplatte bedeckt. In den nach oben offenen Spaltbereich 5a wird beim oben beschriebenen Verfahren mittels einer Austragnadel oder -düse 9 pastöser Klebstoff 11 gedrückt. Die Klebstoffschicht breitet sich auch unter die Glasplatte 7 in den von dieser bedeckten Bereich 5b der Vertiefung 5 (idealerweise) bis zur Kante 3 hin aus und ist auf der anderen Seite durch die aufstehende Außenkante 1 des Tragrahmens begrenzt.

Wird die Austragnadel 9 in der mit dem Pfeil bezeichneten Richtung vorgeschoben und dabei kontinuierlich mit konstanter Austragmenge pro Zeiteinheit Klebstoff ausgetragen, bildet die Klebstoffschicht in Abhängigkeit von der Vorschubgeschwindigkeit eine unterschiedlich geformte Vorderfront 11a aus. Fig. 2A zeigt eine sich bei hoher Vorschubgeschwindigkeit einstellende Klebstoffschicht, während Fig. 2B die Gestalt der Klebstoffschicht bei angemessener Vorschubgeschwindigkeit zeigt. Es ist erkennbar, dass im ersteren Fall die Gefahr besteht, dass die Klebstoffschicht sich nicht bis zur begrenzenden Innenkante 3 der Tragkonstruktion hin erstreckt, für eine Verklebung also nicht die gesamte verfügbare Kontaktfläche der Glasplatte wirksam wird. Andererseits kann (was in den Figuren nicht dargestellt ist) eine zu geringe Vorschubgeschwindigkeit zu einem Klebstoffstau und Ausquellen von Klebstoff aus dem Spaltbereich 5a auf die Oberfläche der Glasplatte und/oder der Außenkante 1 und damit zu einem unsauberen Produkt führen.

Fig. 3 zeigt für die Erläuterung der Erfindung wesentliche Teile einer Anlage 100 zur Herstellung von Solarkollektoren mit dem in Fig. 1 skizzenartig dargestellten Grundaufbau. Die Anlage 100 umfasst eine Video- oder Ultraschall-Kameraeinrichtung 101 mit nachgeordneter Bildverarbeitungseinrichtung 103 zur Extraktion des relevanten Bildinhaltes, nämlich des Verlaufs der Vorderfront einer Klebstoffschicht bei dem oben beschriebenen Verfahren, aus dem Kamerabild. Ausgangsseitig der Bildverarbeitungseinrichtung 103 ist eine Auswertungseinrichtung 105 angeschlossen, der ein Bildmusterspeicher 107 für typische Vorderkantenverläufe von Klebstoffschichten zugeordnet ist und die Vergleichermittel zum Vergleichen eines aktuell aufgenommenen Bildes der Klebstoffschicht-Vorderkante mit vorgespeicherten Bildern umfasst. Im Bildmusterspeicher 107 ist den gespeicherten Verlaufskurven-Bildern jeweils mindestens ein Steuerdatensatz zur Steuerung der eingesetzten Klebstoffaustragvorrichtung zugeordnet. Zur Symbolisierung dieses Umstandes ist in Fig. 3 im Block des Bildmusterspeichers 107 ein Speicherbereich 107a für die Steuerdaten abgegrenzt. In der Praxis werden den einzelnen gespeicherten Vorderfront-Bildern jeweils mehrere Steuerdatensätze für unterschiedliche Klebstoffe und gegebenenfalls unterschiedliche Geometrien der mit Klebstoff zu füllenden Vertiefung zugeordnet sein, wobei für den konkreten Prozess jeweils der zugeordnete Steuerdatensatz vorgewählt bzw. aktiv gehalten wird. Die Steuerdatensätze sind derart gebildet, dass z.B. bei Erfassung eines optimalen Vorderfront-Verlaufsbildes die eingestellte Vorschubgeschwindigkeit eingehalten wird, während bei einem erfassten Verlaufsbild, welches eine zu hohe Vorschubgeschwindigkeit signalisiert, eine Verringerung der Vorschubgeschwindigkeit und andererseits bei einem Verlaufsbild, welches eine zu geringe Vorschubgeschwindigkeit signalisiert, eine Erhöhung der Vorschubgeschwindigkeit, jeweils um einen für das konkrete Bild vorbestimmten Gradienten bzw. Betrag, eingestellt wird.

In Abhängigkeit vom Auswertungsergebnis adressiert die Auswertungseinrichtung 105 jeweils den Steuerdatensatz, der zu demjenigen Vorderfront-Bild gespeichert ist, welches dem aktuellen Verlauf am nächsten kommt. Der adressierte Steuerdatensatz wird in eine Antriebssteuereinrichtung 109 ausgelesen und dort zur Einstellung der Vorschubgeschwindigkeit in einer Antriebseinrichtung 111 verarbeitet, welche die Klebstoffaustragvorrichtung H zusammen mit der Kammer 101 längs der mit Klebstoff zu füllenden Vertiefung vorschiebt.

Anstelle der Kameraeinrichtung 101 kann in der in Fig. 3 schematisch gezeigten und vorstehend skizzenartig beschriebenen Anlage auch eine Sensoranordnung mit mehreren Sensoren zur punktuellen Erfassung des Verlaufes der Klebstoffschicht-Vorderfront, etwa auf der Basis von punktuellen Leitfähigkeitsmessungen, vorgesehen sein. Die Auswertungseinrichtung 105 und der zugehörige Speicher 107 können in ihrer Funktionalität und ihrem Zusammenwirken anders gestaltet sein; insbesondere kann der Zugriff auf vorbestimmte Steuerdatensätze anders organisiert oder durch die Echtzeitberechnung von jeweils aktuellen Steuerdatensätzen aus Merkmalen des erfassten Bildes der Klebstoffschicht-Vorderfront aufgrund eines vorbestimmten Algorithmus ersetzt sein. Auch im Übrigen liegen, im Rahmen der anhängenden Ansprüche, zahlreiche Modifikationen gegenüber den vorstehend beschriebenen Ausführungsbeispielen und -aspekten im Bereich der Erfindung, die der Fachmann ohne eigenes erfinderisches Zutun findet.

## Patentansprüche

1. Verfahren zur Herstellung einer Verbundkonstruktion mit einem rahmen-oder wannenförmigen Trägerteil (T) und einer in dieses eingefügten und an ihren Kanten mit dem Trägerteil verklebten Platte (G; 7),
wobei Klebstoff (11) aus einer längs der Kante der Platte vorgeschobenen Klebstoffaustragvorrichtung (H; 9) fortschreitend in eine längs der Kante der Platte verlaufende Vertiefung (5) ausgetragen wird, die sich von einer außerhalb der Projektion der Platte auf das Trägerteil liegenden Außenkante (1) bis zu einer innerhalb der Projektion liegenden Innenkante (3) erstreckt,
wobei der Verlauf der Vorderfront (11a) einer sich beim fortschreitenden Klebstoffaustrag in der Vertiefung bildenden Klebstoffschicht (11) bildgebend oder sensorisch erfasst und ausgewertet und die Vorschubgeschwindigkeit der Klebstoffaustragvorrichtung und/oder die Klebstoff-Austragmenge pro Zeiteinheit in Abhängigkeit vom Auswertungsergebnis gesteuert wird.

2. Verfahren nach Anspruch 1, wobei bei konstant gehaltener Klebstoffaustragmenge pro Zeiteinheit nur die Vorschubgeschwindigkeit in Abhängigkeit vom Austragergebnis verändert wird.

3. Verfahren nach Anspruch 1 oder 2, wobei die Auswertung einen Muster-oder Koordinatensatz-Vergleich eines in Echtzeit erfassten Bildes oder Koordinatensatzes mit gespeicherten Bildern oder Punktscharen von Vorderfronten umfasst.

4. Verfahren nach Anspruch 3, wobei jedem Bild oder jeder Punktschar ein Steuerdatensatz zugeordnet ist, welcher bei Erkennung einer Übereinstimmung im Mustervergleich zur Steuerung der Vorschubgeschwindigkeit und/oder Klebstoffaustragmenge pro Zeiteinheit benutzt wird.

5. Verfahren nach einem der vorangehenden Ansprüche, wobei im sichtbaren Bereich oder IR-Bereich ein Kamerabild der Vorderfront (11a) aufgenommen wird.

6. Verfahren nach einem der Ansprüche 1 bis 4, wobei eine Ultraschall-Abbildung der Vorderfront (11a) aufgenommen wird.

7. Verfahren nach einem der Ansprüche 1 bis 4, wobei Daten von Leitfähigkeitsmessungen auf vorbestimmten Linien längs der Kante der Platte zwischen Außen- und Innenkante (1, 3) der Vertiefung (5) erfasst und hieraus jeweils den Verlauf der Vorderfront (11a) charakterisierende Koordinatensätze gewonnen werden.

8. Verfahren nach einem der vorangehenden Ansprüche, ausgestaltet als Verfahren zur Herstellung eines Sonnenkollektors oder Solarmoduls.

9. Verfahren nach einem der Ansprüche 1 bis 7, ausgestaltet als Verfahren zur Herstellung eines Verglasungselementes.

10. Anordnung zur Herstellung einer Verbundkonstruktion mit einem rahmen-oder wannenförmigen Trägerteil (T) und einer in dieses eingefügten und an ihren Kanten mit dem Trägerteil verklebten Platte (G; 7), wobei Klebstoff (11) aus einer längs der Kante der Platte vorgeschobenen Klebstoffaustragvorrichtung (H; 9) fortschreitend in eine längs der Kante der Platte verlaufende Vertiefung (5) ausgetragen wird, die sich von einer außerhalb der Projektion der Platte auf das Trägerteil liegenden Außenkante (1) bis zu einer innerhalb der Projektion liegenden Innenkante (3) erstreckt,
mit einer Bildaufnahme- oder Sensoranordnung (101, 103) zur Erfassung des Verlaufs der Vorderfront (11a) einer sich beim fortschreitenden Klebstoffaustrag in der Vertiefung bildenden Klebstoffschicht (11),
einer mit der Bildaufnahme- oder Sensoreinrichtung verbundenen Auswertungseinrichtung (105, 107) zur Auswertung des bildgebend oder sensorisch bestimmten Verlaufs der Vorderfront und
einer mit der Auswertungseinrichtung verbundenen Steuereinrichtung (109) zur Steuerung der Vorschubgeschwindigkeit der Klebstoffaustragsvorrichtung und/oder der Klebstoff-Austragmenge pro Zeiteinheit.

11. Anordnung nach Anspruch 10, wobei die Bildaufnahme- oder Sensoreinrichtung (101) mit der Klebstoffaustragsvorrichtung gekoppelt ist und mit dieser vorgeschoben wird, derart, dass jeweils nur ein Bereich der Kante der Platte bildgebend oder sensorisch erfasst wird, indem sich die Vorderkante der Klebstoffschicht ausbildet.

12. Anordnung nach Anspruch 10 oder 11, wobei die Bildaufnahmeeinrichtung (101) eine im sichtbaren Bereich oder IR-Bereich empfindliche Kamera aufweist.

13. Anordnung nach Anspruch 10 oder 11, wobei die Bildaufnahmeeinrichtung (101) eine bildgebende Ultraschallsende- und -empfangseinrichtung aufweist.

14. Anordnung nach Anspruch 10 oder 11, wobei die Sensoreinrichtung eine mit einer Mehrzahl von fest bezüglich der Klebstoffaustragsvorrichtung angeordneten Sensoren versehene Leitfähigkeits-Messanordnung ist.
